# EUROPEAN PATENT SPECIFICATION

(11) **EP 3 522 237 B1**
(45) Date of publication and mention of the grant of the patent: **16.06.2021**
(21) Application number: 17855326.9
(22) Date of filing: 29.06.2017
(51) Int. Cl.: H01L 31/05, H01L 31/02, H01L 31/049

(54) **SOLAR CELL MODULE**
SOLARZELLENMODUL
MODULE DE CELLULES SOLAIRES

(30) Priority: 27.09.2016 JP 2016188850
(43) Date of publication of application: 07.08.2019
(73) Proprietor: Kaneka Corporation, Osaka-shi, Osaka 530-8288 (JP)
(72) Inventor: TERASHITA, Toru, Settsu-shi, Osaka 566-0072 (JP); KOIZUMI, Gensuke, Settsu-shi, Osaka 566-0072 (JP)
(74) Representative: V.O.
(86) International application number: PCT/JP2017/024040
(87) International publication number: WO 2018/061367

(56) References cited:
- JP-A- 2002 252 364
- JP-A- 2003 086 820
- JP-A- 2008 502 149
- JP-A- 2010 087 011
- US-A1- 2005 268 959
- US-A1- 2016 149 065
- US-A1- 2016 260 854
- DAVIDSEN RASMUS SCHMIDT ET AL: "Black silicon solar cells with black bus-bar strings", 2016 IEEE 43RD PHOTOVOLTAIC SPECIALISTS CONFERENCE (PVSC), IEEE, 5 June 2016 (2016-06-05), pages 2885-2888, XP033008186, DOI: 10.1109/PVSC.2016.7750183 [retrieved on 2016-11-18]

## Description

### TECHNICAL FIELD

The present invention relates to a solar cell module in which a plurality of solar cells are connected through a wiring member.

### BACKGROUND ART

Solar cells that include crystalline semiconductor substrates such as a single-crystalline silicon substrate and a polycrystalline silicon substrate have a small area for one substrate, and thus in practical use, a plurality of solar cells are electrically connected and modularized for increasing output. A wiring member composed of a metal foil, etc. is connected to an electrode of a solar cell through solder, a conductive adhesive or the like to electrically connect adjacent solar cells. A solar cell string in which a plurality of solar cells are connected through a wiring member is encapsulated between a light-receiving-surface protection member and a back-surface protection member to obtain a solar cell module.

The solar cell exhibits a black color when viewed from the light-receiving side, whereas the wiring member has metallic luster. Thus, when a solar cell module is installed on a roof or a wall surface of a building, reflected light of sunlight applied to a wiring member is visually recognized, so that the visuality is impaired. In particular, a back contact solar cell has no electrode on the light-receiving surface, and has electrodes only on the back surface, so that light reflected by the wiring member is apt to be conspicuous.

Patent Document 1 suggests that the visuality of a module is improved by ensuring that a wiring member positioned between adjacent solar cells is similar in color to a back-surface protection member. In Patent Document 2, a shield composed of an insulating tape or the like is positioned between adjacent solar cells to cut off the view of the wiring member from the light-receiving side, so that the visuality of the module is improved.

The document Davidsen et al., "Black silicon solar cells with black bus-bar strings", 2016 IEEE 43rd Photovoltaic Specialists Conference (PVSC), 5 June 2016, pages 2885-2888, further discloses a solar cell module in which the solar cells, the back-surface protection member and the cell connecting members are black on the light-receiving surface.

### PRIOR ART PATENT DOCUMENTS

Patent Document 1: Japanese Patent Laid-open Publication JP 2010-87011
Patent Document 2: National Publication of International Patent Application WO 2008/502149

### SUMMARY OF THE INVENTION

### PROBLEMS TO BE SOLVED BY THE INVENTION

An object of the present invention is to provide a solar cell module in which an electrode, a wiring member, etc. are hardly visually recognized, so that an excellent visuality is exhibited.

### MEANS FOR SOLVING THE PROBLEMS

A solar cell of the present invention includes a solar cell string in which a plurality of rectangular solar cells each having a light-receiving surface and a back surface are electrically connected along a first direction, the light-receiving surface having a black color. The solar cell is a back contact solar cell, in which no metal electrode is provided on the light-receiving surface and metal electrodes are disposed only on the back surface. The solar cell string is sandwiched between a light-transmissive light-receiving-surface protection member disposed on the light-receiving side and a back-surface protection member disposed on the back side, and is encapsulated with an encapsulant. The principal surface on the light-receiving side of the back-surface protection member has a black color.

The solar cell string includes a cell connecting member such as a conductive wiring member positioned between solar cells adjacent in a first direction. A portion of the cell connecting member, which is exposed to the light-receiving surface, has a black color. A lateral surface at a second direction end of the cell connecting member is similar in color to the light-receiving surface of the solar cell, and is situated in line with the lateral surface of the solar cell, wherein the second direction is orthogonal to the first direction.

### EFFECTS OF THE INVENTION

In the solar cell module of the present invention, a portion exposed to the light-receiving side of a cell connecting member is similar in color to the light-receiving surface of a solar cell, and therefore the cell connecting member is hardly visually recognized. Further, since the positions of the end races of the solar cell and the cell connecting member are aligned, and the lateral surface of the connecting member is similar in color to the solar cell, boundaries between the members are hardly visually recognized, so that an excellent visuality is exhibited. Furthermore, since the positions of the end races of the solar cell and the cell connecting member are aligned, it is easy to adjust the positions of the solar cell and the wiring member during preparation of the solar cell module, so that excellent productivity is exhibited.

### BRIEF DESCRIPTION OF THE DRAWINGS

FIG. 1 is a schematic sectional view of a solar cell module according to one embodiment.
FIG. 2A is a plan view of a back surface of a solar cell grid according to one embodiment.
FIG. 2B is a plan view of a light-receiving surface of a solar cell grid according to one embodiment.
FIG. 3 is a sectional view of a solar cell module according to one embodiment.
FIG. 4A is a plan view of a back surface of a solar cell grid according to one embodiment.
FIG. 4B is a plan view of a light-receiving surface of a solar cell grid according to one embodiment.
FIG. 5 is a plan view of a back surface of a solar cell string according to one embodiment.
FIG. 6 is a plan view of a back surface of a solar cell string according to one embodiment.

### MODE FOR CARRYING OUT THE INVENTION

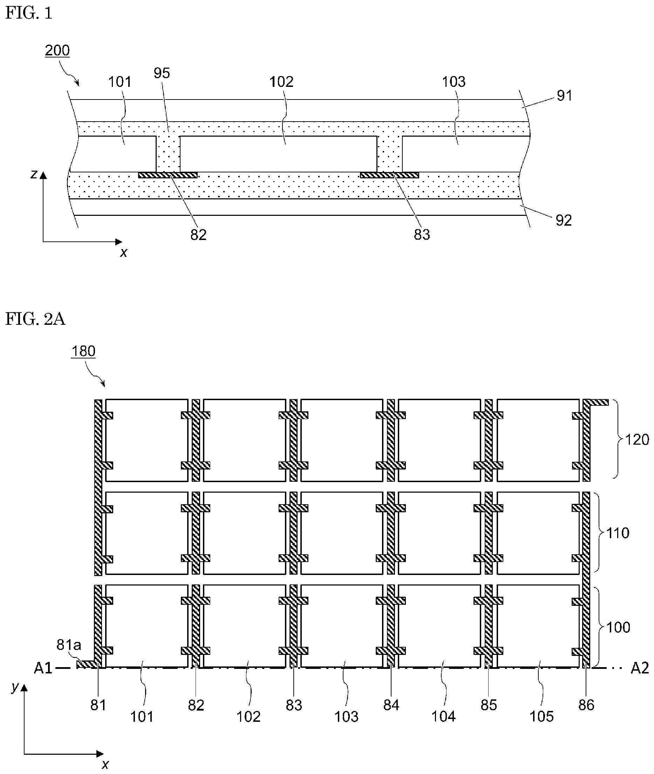

FIG. 1 is a schematic sectional view of a solar cell module (hereinafter referred to as a "module") according to one embodiment. A module 200 shown in FIG. 1 includes a solar cell string in which plurality of solar cells (hereinafter referred to as "cells") 101, 102 and 103 are electrically connected through wiring members 82 and 83.

A light-receiving-surface protection member 91 is disposed on the light-receiving side (the upper side in FIG. 1) of the solar cell string, and a back-surface protection member 92 is disposed on the back side (the lower side in FIG. 1) of the solar cell string. In the module 200, the solar cell string is encapsulated by filling the space between the protection members 91 and 92 with an encapsulant 95.

As the cell, a back contact solar cell (back contact cell) is used. The back contact cell has a p-type semiconductor layer and an n-type semiconductor layer on the back side of a semiconductor substrate of crystalline silicon or the like, and a metal electrode is disposed on each of the p-type semiconductor layer and the n-type semiconductor layer. The metal electrode can be formed by a known method such as printing or plating. For example, an Ag electrode formed by screen printing of an Ag paste, a copper-plated electrode formed by electroplating, or the like is preferred.

The back contact solar cell does not have a metal electrode on the light-receiving surface of the semiconductor substrate, and photocarriers (holes and electrons) generated in the semiconductor substrate are collected by the metal electrode disposed on the back side of the semiconductor substrate. Since the back contact solar cell does not have a metal electrode on the light-receiving surface, the entire surface of the cell is uniformly colored black when the cell is viewed from the light-receiving side, so that an excellent visuality is exhibited.

Electrodes disposed on the back side of cells 101, 102 and 103 are electrically connected through wiring members 82 and 83 to form a solar cell string. A plurality of cells is connected in series by connecting the p-side electrode of one of two adjacent cells to the n-side electrode of the other cell through the wiring member. The cells can also be connected in parallel by connecting n-side electrodes or p-side electrodes of adjacent cells.

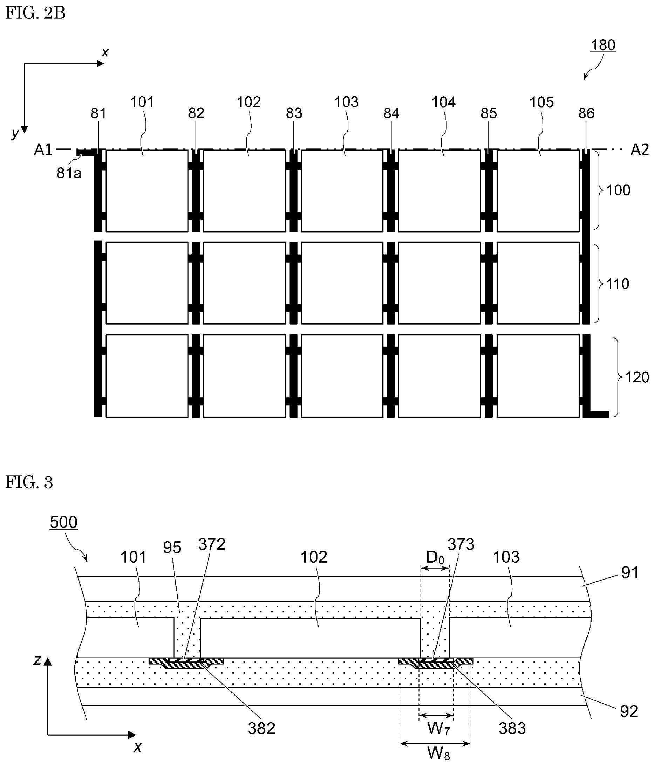

FIGS. 2A and 2B are plan views of a solar cell grid in which a plurality of back contact cells are arranged in a grid shape. FIGS. 2A and 2B are plan views of the solar cell grid on the back side and on the light-receiving side, respectively. In a solar cell grid 180, solar cell strings 100, 110, and 120 in which a plurality of cells are connected along a first direction (x direction) are arranged side by side along a second direction (y direction) orthogonal to the first direction. In this specification, a form in which a plurality of cells are connected along one direction is referred to as a "solar cell string", and a form in which a plurality of solar cell strings are arranged in a direction orthogonal to the cell connection direction in a solar cell string is referred to as a "solar cell grid".

The solar cell string 100 includes a plurality of cells 101 to 105 arranged in a first direction, and electrodes of adjacent cells are connected through conductive wiring members 82 to 85. Each cell has a rectangular shape in plan view. The term "rectangular shape" includes a square shape. The "rectangular shape" is not required to be a perfectly square shape or oblong shape, and for example, the semiconductor substrate may have a semi-square shape (a rectangular shape having rounded corners, or a shape having a notched portion). The positions of the second-direction end races of cells 101 to 105 are aligned along line A1-A2, and the cells 101 to 105 are arranged in a straight line.

The wiring member 81 arranged at one end portion in the first direction includes a lead wire 81a which can be connected to an external circuit. The wiring member 86 arranged at the other end portion in the first direction is connected to the solar cell string 110 adjacent in the second direction. Preferably, the material of the wiring member has a low resistivity. In particular, a metallic material mainly composed of copper is especially preferable because it is inexpensive.

The wiring member and the metal electrode disposed on the back surface of the cell are connected with solder, etc. A conductive wiring pad (not shown) may be disposed between the cell and the wiring member. The electrode disposed on the back surface of the cell has a small width, and therefore by connecting the electrode to the wiring member through the wiring pad, the contact area is increased, and adjustment of positions during interconnection is facilitated.

As shown in FIG. 2B, the wiring member is exposed to the light-receiving side in a gap portion between adjacent cells. Thus, in a module installed on a roof, a wall or the like, the wiring member exposed in a gap between adjacent cells is visible. In the module of the present invention, a portion exposed to the light-receiving surface of a cell connecting member such as the wiring member is similar in color to the light-receiving surface of the cell. In the back contact cell, the light-receiving surface of the cell has a black color, and therefore when the light-receiving surface of the wiring member has a black color similar to that of the light-receiving surface of the cell, a boundary between the cell and the wiring member is hardly visually recognized, so that the visuality is improved.

In the solar cell string 100, the positions of the second-direction end races of the cells 101 to 105 and the wiring members 82 to 85 connecting adjacent cells are aligned. That is, the lateral surfaces of the second-direction end portions of the cells 101 to 105 and the wiring members 82 to 85 are situated on the same line (line A1-A2). In the second-direction end race (surface along line A1-A2), the lateral surfaces of the cells 101 to 105 are similar in color to the lateral surfaces of the wiring members 82 to 85.

When the cell is similar in color to the wiring member, and the positions of the end races of the cell and the wiring member are aligned at the position of line A1-A2, the pattern shape of the wiring member is hardly visually recognized at the time of viewing the module from the light-receiving surface. In addition, by aligning the position of the end race of a cell connecting member such as the wiring member and the position of the end race of the cell, adjustment of positions during preparation of the solar cell string is facilitated, so that the productivity of the module can be improved.

When the module is viewed from the front side of the light-receiving surface, the lateral surface of the cell or the wiring member is not visible, but the module is often installed inclined, and in a module installed on a roof or a wall surface, the lateral surface of the cell or lateral surface of the wiring member may be visible. In a module composed of back contact cells having no metal electrode on the light-receiving surface and a wiring member having a black color on the exposed portion of the light-receiving surface, the entire module is uniformly colored black, even minute reflected light from the lateral surface of the wiring member may be easily visually recognized, resulting in deterioration of the visuality. In particular, when the position of the end race of the cell and the position of the end race of the wiring member are aligned, the lateral surface of the wiring member is easily visible, so that the visuality is apt to be markedly deteriorated due to, for example, metal reflection at the lateral surface of the wiring member.

In the module of the present invention, the lateral surface of the cell and the lateral surface of a cell connecting member such as the wiring member have similar colors at the second-direction end race, and therefore a boundary portion is hardly conspicuous even when the lateral surface is visible. As described above, the module of the present invention has high unity in terms of a color tone as a module as a whole, and is excellent in a visuality.

For ensuring that the light-receiving side principal surface and the lateral surfaces of the wiring member are similar in color to the light-receiving surface of the cell, for example, the surface of the base material such as copper is blackened. Examples of the method for blackening the surface of the base material include formation of a black oxide film and formation of a black metal layer. Examples of the black metal layer include metals and metal oxides including copper, nickel, palladium, chromium and the like, and metals in which carbon nanotubes, carbon or the like are dispersed. The method for forming a metal layer on the surface of the base material is not particularly limited, and a dry process such as a sputtering method, a CVD method, a vacuum vapor deposition method, or a wet process such as application of a metal paste material is applicable. A metal layer may be formed by electroplating or electroless plating.

The entire light-receiving surface of each of the wiring members 82 to 85 may be blackened, or only a region of the light-receiving surface, which is exposed in a gap between adjacent cells, may be blackened. The back surface of the wiring member may be optionally blackened. The wiring members 81 and 86 disposed at both ends of the solar cell string in the first direction are generally hidden behind a frame attached to the module, and are not visible from the outside, and therefore the wiring members 81 and 86 are not required to be similar in color to the cell. When the wiring members 81 and 86 have a portion visible from the light-receiving side in the module, it is preferable that at least the portion visible from the light-receiving side is similar in color to the light-receiving surface of the cell.

In fabrication of the solar cell string, the cell and the wiring member are connected via solder, etc. Here, the cell and the wiring member are arranged in such a manner that the end races are aligned in a direction (second direction) orthogonal to the cell connection direction (first direction). Generally, since a semiconductor substrate that forms a cell has a size tolerance of about 1 to 2 mm, it is difficult to completely align the positions of both end faces in the second direction. Thus, the cell and the wiring member may be aligned at one of the second-direction end races.

When the end race is used as a reference, it is easy to adjust the positions of the cell and the wiring member, and therefore productivity can be improved. In a module installation environment, the end face positioned on the lower side (side close to the ground) is easily visible from the outside. Thus, when the positions of the cell and the wiring member are adjusted using as a reference an end face positioned on the lower side in the module installation environment, the positions of the end races on the lower side are aligned, and therefore a boundary between members is hardly visually recognized, so that the visuality is improved.

A plurality of cells is connected along the first direction to prepare a string, and a plurality of strings are arranged in the second direction and electrically connected to obtain a solar cell grid. The solar cell grid is sandwiched between the light-receiving-surface protection member 91 and the back-surface protection member 92 with the encapsulant 95 interposed therebetween, whereby a module is formed.

Preferably, a transparent resin such as a polyethylene-based resin composition mainly composed of an olefin-based elastomer, polypropylene, an ethylene/α-olefin copolymer, an ethylene/vinyl acetate copolymer (EVA), an ethylene/vinyl acetate/triallyl isocyanurate (EVAT), polyvinyl butyrate (PVB), silicon, urethane, acrylic or epoxy is used as the encapsulant 95. Materials of the encapsulants on the light-receiving side and the back side may be the same or different.

For the light-receiving-surface protection member 91, which is light-transmissive, glass, transparent plastic or the like is used. In the back-surface protection member 92, a surface on the light-receiving side (surface facing to the cell) is similar in color to light-receiving surface of the cell. In a portion where a cell is not disposed, the back-surface protection member 92 is visible from the light-receiving side, and therefore the back-surface protection member influences the appearance of the module. When the surface of the back-surface protection member on the light-receiving side is similar in color to the light-receiving surface of the cell and the wiring member, the color tone of the module as a whole is unified, and therefore the visuality is improved.

As the back-surface protection member, a resin sheet including a black resin layer is preferably used. The black resin sheet to be used for the back-surface protection member may include a black resin layer on the light-receiving side visible from the outside. The entire black sheet may be a black resin layer. The black resin layer has visible light-absorbency, and mainly absorbs visible light having a wavelength of 800 nm or less. The visible light transmittance of the black resin layer is preferably 10% or less. As a black resin layer, a resin composition containing a thermoplastic resin such as a polyolefin-based resin, a polyester-based resin, an acryl-based resin, a fluororesin or an ethylene-vinyl acetate resin and a colorant such as a pigment or a dye is preferably used.

Preferably, a stack in which the light-receiving surface encapsulant, the solar cell string (or a solar cell grid in which a plurality of solar cell strings are connected), the back surface encapsulant and the back-surface protection member are arranged in this order on the light-receiving-surface protection member is heated at predetermined conditions to cure the encapsulant. The module after encapsulation is mounted to an aluminum frame or the like as necessary.

Although FIG. 1 shows an example in which only a conductive wiring member is present as a cell connecting member positioned between adjacent cells, the cell connecting member may include members other than the wiring member. For example, the cell connecting member may include a shielding sheet for cutting off the view of the wiring member from the light-receiving side as a member other than the wiring member.

FIG. 3 is a schematic sectional view of a module including a shielding sheet on the light-receiving side of the wiring member. In the module 500 shown in FIG. 3, the shielding sheets 372 and 373 are arranged on the light-receiving side of the wiring members 382 and 383 which electrically connect the adjacent cells 101, 102 and 103.

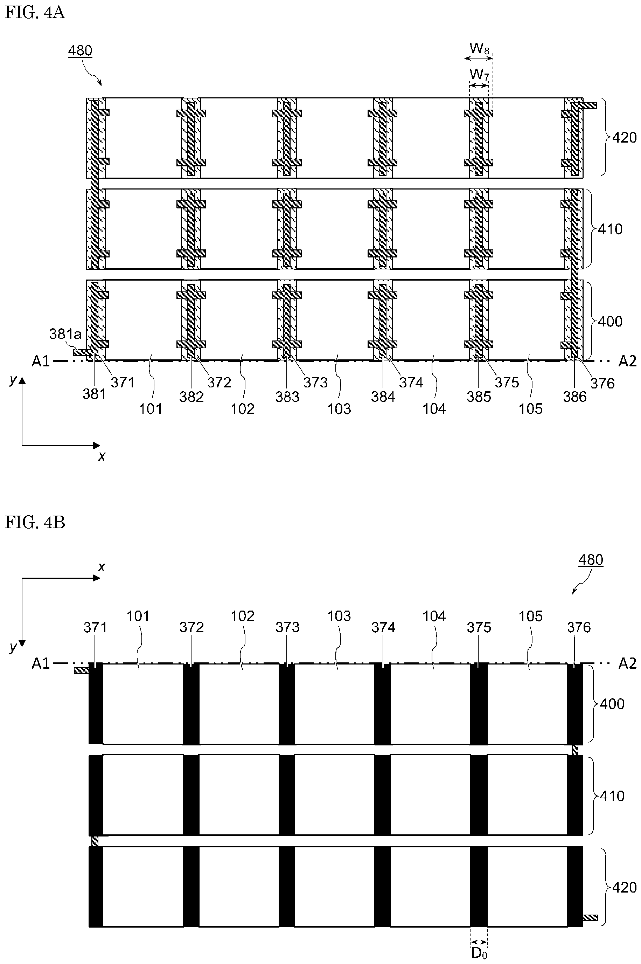

FIGS. 4A and 4B are plan views of a solar cell grid in which a shielding sheet is disposed on the light-receiving side of the wiring member. FIGS. 4A and 4B are plan views on the back side and on the light-receiving side, respectively. In this embodiment, the second-direction end races of cells 101 to 105 are aligned along line A1-A2, and the cells 101 to 105 are arranged in a straight line.

In the shielding sheets 372 to 375 positioned in gaps between adjacent cells, the width W₇ in the first direction is larger than the distance D₀ between adjacent cells as shown in FIGS. 3 and 4A. In addition, in the first direction, the width W₇ of the shielding sheet is smaller than the width W₈ of the wiring member. In a portion which is not covered with the shielding sheet on the back side of the cell, the wiring member is electrically connected to the back electrode of the cell. In the second direction, the length of the shielding sheet is preferably equal to the length of the cell. The length of the wiring member in the second direction is equal to or less than the length of the shielding sheet. Thus, in a gap between adjacent cells, the entire wiring member is covered with the shielding sheet. When the module is viewed from the light-receiving side, the wiring member arranged on the back side of the shielding sheet is not visible, and only the shielding sheet exposed in a gap between adjacent cells is visible.

In this embodiment, the cell connecting member includes the wiring member and the shielding sheet, and the light-receiving surface of the shielding sheet corresponds to a portion of the cell connecting member, which is exposed to the light-receiving surface. When the light-receiving surface of the shielding sheet is similar in color to the cell, a boundary between the cell and the cell connecting member is hardly visually recognized, so that the visuality of the module is improved.

In a solar cell string 400, the positions of the second-direction end races of cells 101 to 105 and shielding sheets 372 to 375 positioned between the cells are aligned. In the second-direction end race (surface along line A1-A2), the lateral surfaces of the cells 101 to 105 are similar in color to the lateral surfaces of the shielding sheets 372 to 375.

In this embodiment, metal reflection of the wiring member is not visible from the outside since the wiring member is covered with the shielding sheet. In addition, since the cell is similar in color to the shielding sheet, and the end races of the cell and the shielding sheet are aligned at the position of line A1-A2, a boundary portion is inconspicuous even when the lateral surface of the module is viewed in an installation environment. Thus, the module of this embodiment has an excellent visuality. In this embodiment, by aligning the position of the end race of the shielding sheet and the position of the end race of the cell, adjustment of positions during preparation of the solar cell string is facilitated, so that the productivity of the module can be improved.

In this embodiment, the wiring member is not visible from the outside of the module, and therefore the surface of the wiring member may have metallic luster. The length of the shielding sheet in the second direction is preferably larger than the length of the wiring member for suppressing deterioration of the visuality due to visibility of the wiring member from the lateral surface (end face in the second direction) of the module. When the length of the shielding sheet in the second direction is equal to the length of the wiring member, it is preferable that the second-direction end race of the wiring member is colored in similar color as to that of the solar cell.

The material of the shielding sheet for cutting of the view of the wiring member from the light-receiving side is not particularly limited. For example, the same material as that of the black sheet to be used as a back-surface protection member can be used. When the material of the shielding sheet is identical to the material of the back-surface protection member, a boundary between the shielding sheet and the back-surface protection member is hardly visually recognized, so that the visuality of the module is improved.

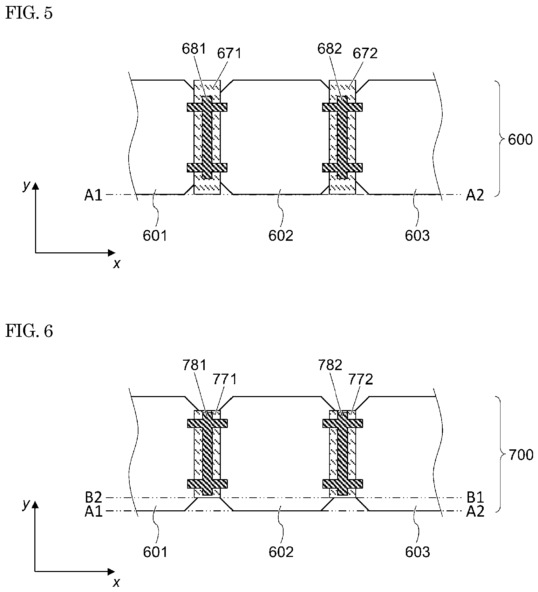

As described above, the shape of the cell in the module of the present invention may be a semi-square shape such as a rectangular shape having rounded corners, or a shape having a notched portion. When the shape of the cell is a semi-square shape, it is preferable that the end races of the cell connecting members (shielding sheets 671 and 672) and the end races of the cells 601, 602 and 603 in the second direction (y direction) are aligned along line A1-A2 as in the solar cell string 600 shown in FIG. 5.

When a cell with a semi-square shape is used, the end races of the cell connecting members (shielding sheets 771 and 772) in the second direction may be aligned along imaginary line B1-B2 connecting the tops of the notched portions of the cells 601, 602 and 603 as in the solar cell string 700 shown in FIG. 6. In this configuration, the positions of the tops of the notch portions of the cells and the end races of the cell connecting members may be aligned during preparation of the solar cell string, and therefore it is easy to adjust positions.

### DESCRIPTION OF REFERENCE SIGNS

- 101 to 105: solar cell
- 81 to 86, 381 to 386: wiring member
- 371 to 376: shielding sheet
- 100, 110, 120, 400, 410, 420: solar cell string
- 180, 480: solar cell grid
- 91: light-receiving-surface protection member
- 92: back-surface protection member
- 95: encapsulant
- 200, 500: solar cell module

## Claims

1. A solar cell module (20) comprising:
a solar cell string (100) in which a plurality of rectangular solar cells (101, 102, 103) each having a light-receiving surface and a back surface are electrically connected along a first direction, the light-receiving surface having a black color;
a light-transmissive light-receiving-surface protection member (91) disposed on a light-receiving side of the solar cell string;
a back-surface protection member (92) disposed on a back side of the solar cell string; and
an encapsulant (95) arranged between the light-receiving-surface protection member and the back-surface protection member to encapsulate the solar cell string,
wherein
the solar cell has no metal electrode on the light-receiving surface, and has a metal electrode only on the back surface,
the solar cell string includes a cell connecting member positioned between solar cells adjacent in a first direction,
a principal surface of the back-surface protection member on the light-receiving side has a black color, and
a portion of the cell connecting member exposed to the light-receiving surface has a black color, **characterized in that**
a lateral surface at a second direction end of the cell connecting member has a black color, and is situated in line with the lateral surface of the solar cell, wherein the second direction is orthogonal to the first direction.

2. The solar cell module according to claim 1, wherein
the cell connecting member positioned between solar cells adjacent in the first direction is a conductive wiring member (81-86) for connecting electrodes of the adjacent solar cells, and
a light-receiving side principal surface and a lateral surface of a second-direction end portion of the wiring member are has a black color.

3. The solar cell module according to claim 1, wherein
the cell connecting member positioned between solar cells adjacent in the first direction includes: a conductive wiring member (81-86) for connecting electrodes of the adjacent solar cells; and a shielding sheet (371-376) disposed on the light-receiving side of the wiring member,
in a region of a gap portion of solar cells adjacent in the first direction, the shielding sheet is disposed so as to cover the whole of the wiring member on the light-receiving side, and
a principal surface of the shielding sheet on the light-receiving side has a black color.

## Patentansprüche

1. Solarzellenmodul (20), umfassend:
eine Solarzellenkette (100), in der eine Vielzahl von rechteckigen Solarzellen (101, 102, 103), die jeweils eine Lichtempfangsfläche und eine Rückfläche aufweisen, entlang einer ersten Richtung elektrisch verbunden sind, wobei die Lichtempfangsfläche eine schwarze Farbe aufweist;
ein lichtdurchlässiges Lichtempfangsflächen-Schutzelement (91), das auf einer Lichtempfangsseite der Solarzellenkette angeordnet ist;
ein Rückseiten-Schutzelement (92), das auf einer Rückseite der Solarzellenkette angeordnet ist; und
ein Verkapselungsmaterial (95), das zwischen dem Lichtempfangsflächen-Schutzelement und dem Rückseiten-Schutzelement angeordnet ist, um die Solarzellenkette zu verkapseln,
wobei:
die Solarzelle keine Metallelektrode auf der Lichtempfangsfläche hat, und nur eine Metallelektrode auf der Rückfläche aufweist,
die Solarzellenkette ein Zellverbindungselement einschließt, das zwischen den in einer ersten Richtung benachbarten Solarzellen positioniert ist,
eine Hauptoberfläche des Rückseiten-Schutzelements auf der Lichtempfangsseite eine schwarze Farbe aufweist, und,
ein Abschnitt des Zellverbindungselements, der der Lichtempfangsfläche ausgesetzt ist, eine schwarze Farbe aufweist,
**dadurch gekennzeichnet, dass**
eine seitliche Oberfläche an einem Ende des Zellenverbindungselements in einer zweiten Richtung eine schwarze Farbe aufweist und in einer Linie mit der seitlichen Oberfläche der Solarzelle angeordnet ist, wobei die zweite Richtung orthogonal zu der ersten Richtung ist.

2. Solarzellenmodul nach Anspruch 1, wobei
das Zellverbindungselement, das zwischen in der ersten Richtung benachbarten Solarzellen positioniert ist, ein leitendes Verdrahtungselement (81-86) zum Verbinden von Elektroden der benachbarten Solarzellen ist, und eine Hauptoberfläche der Lichtempfangsseite und eine seitliche Oberfläche eines Endabschnitts des Verdrahtungselements in der zweiten Richtung eine schwarze Farbe aufweisen.

3. Solarzellenmodul nach Anspruch 1, wobei
das Zellverbindungselement, das zwischen in der ersten Richtung benachbarten Solarzellen positioniert ist, einschließt: ein leitendes Verdrahtungselement (81-86) zum Verbinden von Elektroden der benachbarten Solarzellen; und ein Abschirmblech (371-376), das auf der Lichtempfangsseite des Verdrahtungselements angeordnet ist,
in einem Bereich eines Spaltabschnitts von Solarzellen, der in der ersten Richtung benachbart ist, das Abschirmblech so angeordnet ist, dass es das gesamte Verdrahtungselement auf der Lichtempfangsseite abdeckt, und eine Hauptoberfläche des Abschirmblechs auf der Lichtempfangsseite eine schwarze Farbe hat.

## Revendications

1. Module (20) de cellules solaires comprenant :
une chaîne (100) de cellules solaires dans laquelle une pluralité de cellules solaires rectangulaires (101, 102, 103) ayant chacune une surface réceptrice de lumière et une surface arrière sont connectées électriquement le long d'une première direction, la surface réceptrice de lumière ayant une couleur noire ;
un élément de protection (91) de surfaces réceptrices de lumière, transmettant la lumière, disposé sur une face réceptrice de lumière de la chaîne de cellules solaires ;
un élément de protection (92) de surfaces arrière disposé sur une face arrière de la chaîne de cellules solaires ; et
un matériau d'encapsulation (95) disposé entre l'élément de protection de surfaces réceptrices de lumière et l'élément de protection de surfaces arrière, destiné à encapsuler la chaîne de cellules solaires,
dans lequel
la cellule solaire ne comporte pas d'électrode métallique sur la surface réceptrice de lumière, et comporte une électrode métallique seulement sur la surface arrière,
la chaîne de cellules solaires inclut un élément connecteur de cellules positionné entre des cellules solaires adjacentes dans une première direction,
une surface principale de l'élément de protection de surfaces arrière sur la face réceptrice de lumière a une couleur noire, et
une partie de l'élément connecteur de cellules, exposée à la surface réceptrice de lumière, a une couleur noire,
**caractérisé en ce qu'**une surface latérale à une extrémité dans une seconde direction de l'élément connecteur de cellules a une couleur noire, et est située en ligne avec la surface latérale de la cellule solaire, la seconde direction étant orthogonale à la première direction.

2. Module de cellules solaires selon la revendication 1, dans lequel
l'élément connecteur de cellules positionné entre des cellules solaires adjacentes dans la première direction est un élément de câblage conducteur (81-86) destiné à connecter des électrodes des cellules solaires adjacentes, et
une surface principale de la face réceptrice de lumière et une surface latérale d'une partie d'extrémité dans une seconde direction de l'élément de câblage sont d'une couleur noire.

3. Module de cellules solaires selon la revendication 1, dans lequel
l'élément connecteur de cellules positionné entre des cellules solaires adjacentes dans la première direction inclut : un élément de câblage conducteur (81-86) destiné à connecter des électrodes des cellules solaires adjacentes ; et une feuille de blindage (371-376) disposée sur la face réceptrice de lumière de l'élément de câblage,
dans une région d'une partie intercalaire de cellules solaires adjacentes dans la première direction, la feuille de blindage est disposée de manière à couvrir la totalité de l'élément de câblage sur la face réceptrice de lumière, et
une surface principale de la feuille de blindage sur la face réceptrice de lumière a une couleur noire.
